# EUROPEAN PATENT APPLICATION

(11) **EP 2 884 293 A1**
(43) Date of publication of application: **17.06.2015**
(21) Application number: 13196948.7
(22) Date of filing: 12.12.2013
(51) Int. Cl.: G01R 31/28

(54) **Semiconductor device carrier**

(71) Applicant: Rasco GmbH, 83059 Kolbermoor (DE)
(72) Inventor: Waldauf, Alexander, 6306 Söll (AT)
(74) Representative: Grünecker Patent- und Rechtsanwälte PartG mbB

(57) **Abstract**

The invention provides a carrier for carrying a plurality of electronic components, comprising a first plate comprising a plurality of openings each configured to accommodate one of the plurality of electronic components; a second plate arranged parallel to the first plate; tolerance means attached to the second plate; and an actuator moveable with respect to the first plate and the second plate for securing more than one of the plurality of electronic components in the openings of the first plate and in contact with the tolerance means in a clamped state of the carrier.

## Description

### Field of the Invention

The present invention relates to a carrier for holding, transferring and aligning batches of individual electronic components (semiconductor devices).

### Background of the Invention

Electronic components, for example IC chips or Ball Grid Arrays, need to be tested after having been manufactured in a mass production process. The electronic components are tested as strip-shaped composites or as individual components usually grouped in batches. Testing of strip-shaped composites is not considered in the present invention. The batches are moved by some transfer element into a test position. At the test position the electrical terminals of the electronic components of the batch are contacted with some testing head of a testing device. Predetermined tests for particular electronic characteristics of the electronic components of the batch are performed by means of the testing head.

In order to simultaneously test a plurality of electronic components of a batch a plurality of electrical contacts have to be provided in the testing head and highly accurate alignment of the electrical contacts of the testing header and the electrical terminals of the individual electronic components of the batch under investigation has to be ensured. In the art, it is known to accommodate individual electronic components in individual receiving pockets of a carrier and transfer the carrier to a testing head where electrical contact is made with the individual electronic components for testing purposes. The carrier, for example, comprises spring elements and stop elements for securing the individual electronic components in the individual receiving pockets (US 7 258 703 and US 2010/0206768 A1).

However, the known conventional securing mechanisms suffer from complicated and expensive constructions. In particular, relatively large spring elements are needed in the art for providing the clamping force for each electronic component. Such spring elements heavily suffer from ageing and restrict the density of receiving pockets and, thus, the number of the individual electronic components that are to be tested. Moreover, the reliability of the fastening of the individual electronic components that are to be transferred and tested should be improved. Therefore, it is an object of the present invention to provide means for holding, transferring and aligning batches of individual electronic components (semiconductor devices), particularly, for testing purposes that overcome the abovementioned problems.

### Description of the Invention

The above-mentioned object is addressed by the carrier for carrying a plurality of electronic components according to claim 1. This carrier comprises
a first plate comprising a plurality of pockets or openings each configured to accommodate one of the plurality of electronic components;
a second plate arranged parallel to the first plate;
tolerance means attached to the second plate and configured for providing tolerances with respect to the actual dimensions of the electronic components and possible contaminations of the electronic components; and
an actuator moveable with respect to the first plate and the second plate for securing more than one of the plurality of electronic components in the pockets or openings of the first plate and in contact with the tolerance means in a clamped state of the carrier.

The openings or pockets may comprise dead stops or edges at which the electronic components are secured in the clamped state of the carrier. The electronic components can be of rectangular shape and, thus, the pockets or openings can also be of rectangular shape. The tolerance means is provided to account for tolerances due to varying sizes of the electronic components, contamination due to dirt, etc. In particular, the tolerance means may comprise or consist of spring-like elements, one provided for each of the electronic components, respectively. It has to be stressed that the tolerance means does not provide the clamping force for securing the electronic components but merely compensates for varying dimensions of the electronic components.

Both the first plate and the second plate can be of rectangular shape and the directions of forces exerted on the electronic components can be substantially parallel to a diagonal of the first and second plates. Insertion of the electronic components into the pockets is performed in an opened state of the carrier. In the opened state enough space is provided in the pockets (openings) to insert the electronic components. For securing the electronic components the actuator is moved parallel and in a predetermined angle with respect to a longitudinal axis of the first and second plates thereby clamping the electronic components between edges of the pockets (openings) of the first plate.

In an opened state of the carrier the electronic components can be inserted. For securing the electronic components the actuator is moved thereby clamping the electronic components in a clamped (secured, locked) state of the carrier. The actuator represents a mechanical means, for example, a structured plate or a bar, that exerts a mechanical force on the clamped electronic components. The actuator may be configured to contact the electronic components by an L-shaped seat, for example. In the art, for each of the electronic components one or more actuators in the form of springs are needed (see description above). In the present invention, by one actuator that is not made of a spring a plurality of electronic components is secured in the clamped state of the carrier. A subset or all of the electronic components may be secured by operation of the actuator. If not all of the electronic components are secured by the actuator one or more additional actuators are provided for securing the remaining electronic components that are not secured by the named actuator. For example, the named actuator may be provided for securing half/third/quarter etc. of the number of the electronic components handled by means of the carrier and another actuator is provided for securing the other half/third/quarter etc. of the number of the electronic components.

Since there is no longer a need for providing one or more springs as actuators for each individual electronic component, the density of electronic components on the carrier can be increased. Moreover, the single mechanical actuator for securing a number of electronic components shows an increased durability as compared to the above-described spring actuators of the art. Safe transfer to and alignment with a testing header of a testing device can be guaranteed. Moreover, the carrier can be produced at relatively low costs due to the relatively simple construction.

The actuator can be opened by a single opener (pushing means) for moving the actuator and the carrier from the clamped state into the opened state. The opener is not part of the carrier. Different from the art there is no need for an individual opener provided for each of the plurality of electronic components. In fact, there may be more than one actuator each being operated by an individual single opener or by one single opener. However, the number of actuators and openers of the inventive carrier is less than the number of electronic components to be handled by means of the carrier.

According to various embodiments the actuator comprises a plurality of clamping elements arranged along a straight line and configured for securing the electronic components in the clamped state. In this embodiment, the actuator may comprise a linear guiding element and the clamping elements are formed on at least one side of the linear guiding element. Moreover, the actuator may comprise a plurality of linear guiding elements each having a plurality of clamping elements formed on at least one side thereof. Thus, simple and reliable configurations can be provided for the actuator.

The tolerance means may comprise elastic means for mechanically contacting/securing the electronic components. As already mentioned some spring-like structure may be comprised in the tolerance means in order to account for production tolerances with respect to the dimensions of the electronic components that might vary according to the particular production conditions. The tolerance means may comprise a plurality of spring-like means each of which comprises a reception means configured for mechanically contacting/securing an electronic component in the clamped state (see detailed description below). In this case, the reception means may be shaped such that it contacts an electronic component in the clamped state at two edges that are connected to each other at a corner. For example, each of the reception means is shaped such that it mechanically contacts/secures the electronic component at the two edges symmetrically. Thereby, a reliable compensation for variations of the dimensions of the electronic components can easily be provided.

The plurality of spring-like means can be integrally formed with a linear member of the tolerance means. It is noted that the tolerance means can be entirely formed of an elastic plastic material or a metal material. Thus, the tolerance means can be easily manufactured in an inexpensive way but, nevertheless, providing compensation for variations of the dimensions of the electronic components in a reliable manner.

The tolerance means and the actuator may, particularly, be formed in the same plane above the second plate to which the tolerance means is attached. The first plate comprising the openings or pockets, in this case, is arranged above both the tolerance means and the actuator. The electronic components are secured by edges of the openings of the first plate and the clamping means of the actuator in this example. Thus, a compact carrier can be provided that reliably secures electronic components in the clamped state.

According to a further embodiment, the carrier comprises a mechanical, in particular, non-elastic, locking means configured for securing the carrier in the clamped state, wherein the locking means is particularly configured for being locked by a pushing means of a loading station. The carried is loaded with the electronic components in the loading station. The locking means may comprise or may be made of a self-locking means, in particular, comprising a metal pin or metal wedge that is configured to be moveable by the pushing means of the loading station. In addition, the actuator may be configured to be actuated by a pushing means of the loading station.

In all of the above-described examples, the actuator is movable for securing or releasing the electronic components. One or more additional actuators may be provided that are operable subsequently or in parallel to the operation of the previously mentioned actuator. The directions of movements of the actuators may be parallel to each other. Thereby, for example, individual rows of electronic components can be dealt with separately.

Further features and advantages of the present invention will be described in the following with reference to the figures, which illustrate only examples of embodiments of the present invention. The illustrated and described features may be suitably combined with each other.
Figures 1a, 1b, 1c and 1d show plan views of an example of a carrier according to the invention wherein the carrier comprises openings for accommodating electronic components, an actuator for securing the electronic components and tolerance means for compensating for variations of the dimensions of the electronic components.
Figure 2 shows a tolerance means comprising spring-like elements of a carrier according to an example of the invention.
Figures 3a and 3b illustrate the tolerance means and a plate to which it is attached as well as an actuator in an open and a clamped state of an example of the inventive carrier, respectively.

The carrier of the present invention can be loaded with electronic components in a loading station. Electronic components, for example, IC chips, that are to be tested by some testing device to which they can be transferred by means of the inventive carrier 1, are to be secured on the carrier. The carrier can be either in an opened state wherein the electronic components are to be inserted or are inserted but not secured or it can be in a clamped (locked, secured) state wherein the electronic components are inserted and secured. Opening and closing of the carrier can be caused by an opener. The opener may comprise an actuating bolt operating on a corner of the carrier, for example.

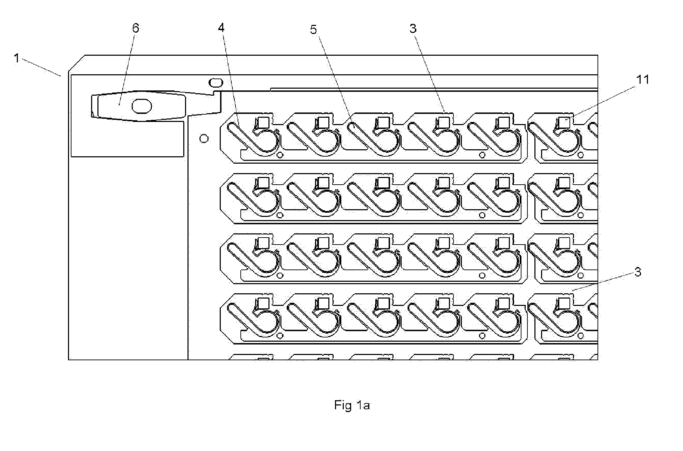

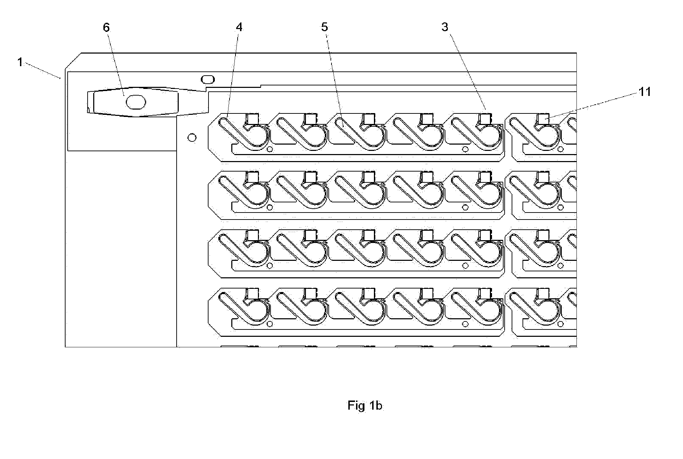

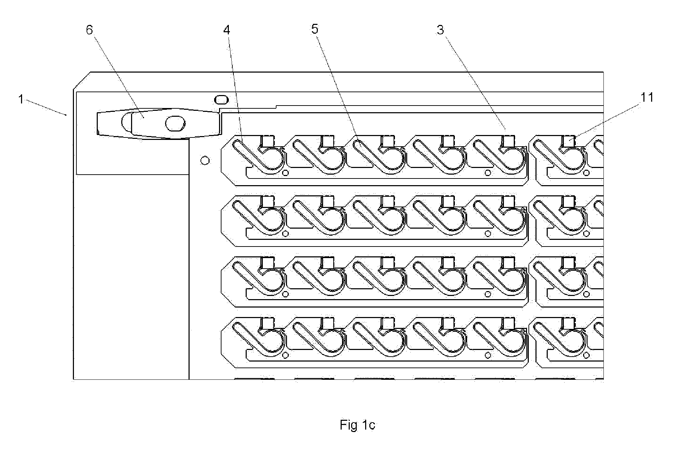

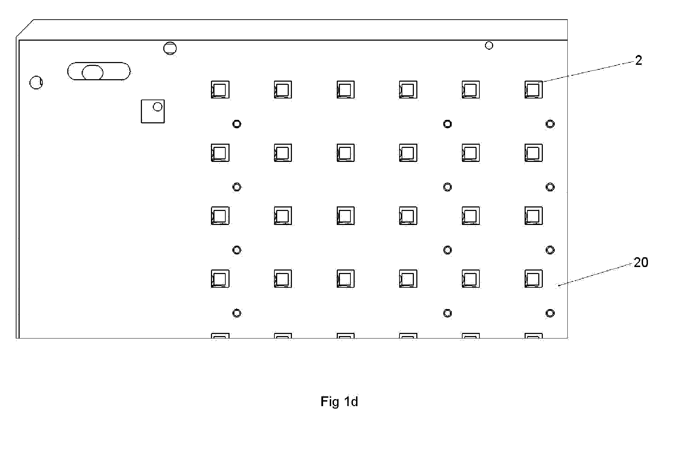

In Figure 1a a plan view of an embodiment of an inventive (clamping) carrier 1 for electronic components 11 is shown. In Figure 1b a clamped state of the carrier 1 shown in Figure 1 a is illustrated and in Figure 1c a secured clamped state of the carrier 1 shown in Figure 1a is illustrated. The carrier 1 comprises a plate 20 with openings 2 as it is shown in Figure 1d (not shown in Figures 1 a to 1c in order to illustrate the underlying components) for accommodating the electronic components 11. The openings or pockets 2 can have substantially rectangular shapes. The carrier 1 also comprises an actuator means 3 that in the opened state shown in Figure 1 a does not exert a mechanical force on the electronic components 11. Transition of the carrier 1 from an opened stated to a clamped state and vice versa is achieved by relative movement of the actuator 3 with respect to the openings 2.

Moreover, for one edge of each opening 2 a tolerance means 4 is provided for compensating for variations of the dimensions of the electronic components 11 (production tolerances). In the shown example, the tolerance means 4 comprises spring-like elements 5, one of each opening 2 In addition, the carrier 1 comprises a a mechanical, in particular, non-elastic, locking means 6 configured for securing the carrier in the clamped state. The locking means 6 is configured for being locked by a pushing means of a loading station. In the shown example, the locking means 6 comprises a self-locking metal wedge.

Figure 1b shows the carrier 1 of Figure 1a in a clamped state. Here, the actuator 3 exerts a mechanical force on the electronic components 11. In fact, the actuator 3 presses the electronic components 11 against edges of the openings 2. However, the tolerance means 4 comprising the individual spring-like elements 5 allows for accounting for tolerances with respect to the dimensions of the electronic components 11 that are to be securely clamped on the carrier 1 in the clamped state shown in Figure 1b. One single opener (pushing means) of a loading station only is needed for operating the actuator 3 that might be realized in form of a plate or bars comprising dead stops for pushing the for securing them in the clamped state. The opener of a loading station, in principle, can be arranged to act along an arbitrarily preselected line of force, for example, in a diagonal or longitudinal direction of the carrier 1. No individual springs are needed as individual actuators exerting forces on individual electronic components 11 and to be operated by individual openers as it is the case in the art. Thus, the inventive carrier 1 exhibits a much more reliable and simpler construction as compared to the art.

Figure 1c shows the carrier 1 in a clamped and secured state. This means, that the individual electronic components 11 are clamped by means of the actuator 3 and that the locking means is pushed in a locked state by means of another actuator of the loading station. After locking the locking means the carrier 1 in the state shown in Figure 1c can be transferred for testing in a testing station, for example. During transfer the electronic components 11 are reliably clamped and secured on the inventive carrier 1.

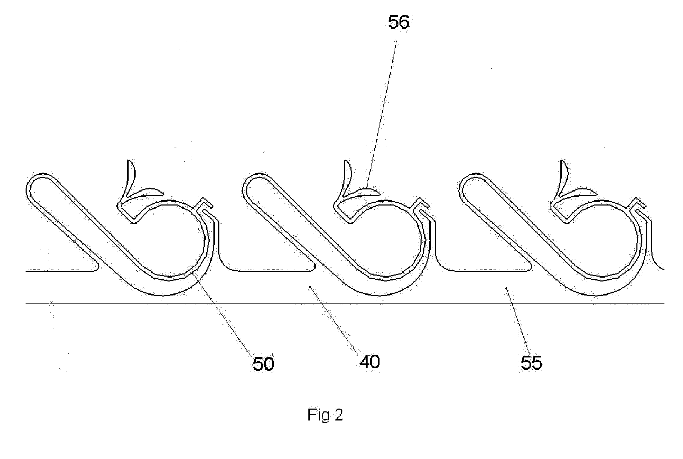

Figure 2 shows a particular example of a tolerance means usable in a carrier, for example, carrier 1 shown in Figures 1 a to 1 c. The tolerance means 40 shown in Figure 2 comprises spring-like elements 50 integrally formed with a linear member 55. The tolerance means 40 is formed of an elastic plastic material. Alternatively, the tolerance means 40 can be made of metal or comprise metal, for example. The spring-like elements 50 end in reception means 56 for contacting electronic components.

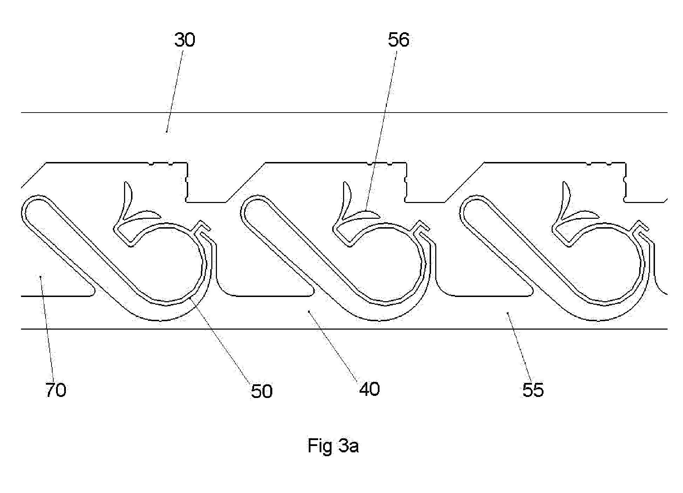

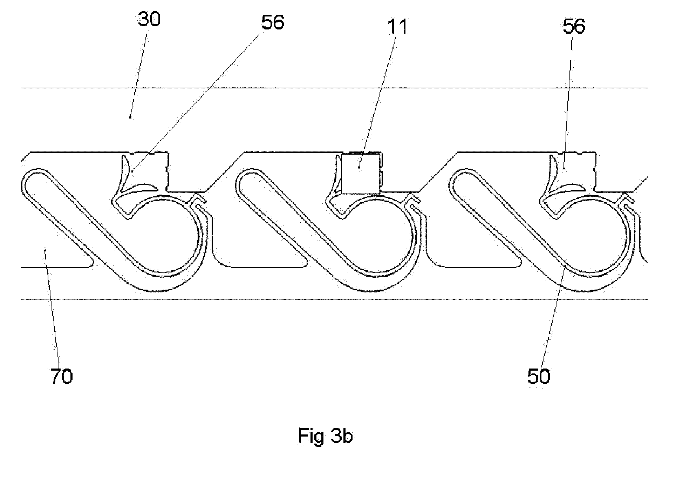

As shown in Figure 3a, the tolerance means 40 can be attached to a plate 70. In the same plane as the tolerance means 40 it is provided an actuator means 30 that is moveable from an open state of a carrier into a clamped state of the same and vice versa. Figure 3b illustrates the configuration shown in Figure 3a in a clamped state. In the clamped state the reception means 56 are in contact with the electronic components in order to account for variations of the dimensions of the electronic components 11. In the embodiment shown in Figure 3a and 3b an additional plate (not shown) comprising openings for accommodating the electronic components is provided for the carrier. In particular, the actuator means 30 can be moved along a direction parallel to a diagonal of the plate to which the tolerance means 40 is attached.

## Claims

1. Carrier for carrying a plurality of electronic components, comprising
a first plate comprising a plurality of openings each configured to accommodate one of the plurality of electronic components;
a second plate arranged parallel to the first plate;
tolerance means attached to the second plate; and
an actuator moveable with respect to the first plate and the second plate for securing more than one of the plurality of electronic components in the openings of the first plate and in contact with the tolerance means in a clamped state of the carrier.

2. The carrier according to claim 1, wherein the tolerance means comprises elastic means for mechanically contacting the electronic components.

3. The carrier according to claim 1 or 2, wherein the actuator comprises a plurality of clamping elements arranged along a straight line and configured for securing the electronic components in the clamped state.

4. The carrier according to claim 3, wherein the actuator comprises a linear guiding element and the clamping elements are formed on at least one side of the linear guiding element.

5. The carrier according to claim 4, wherein the actuator comprises a plurality of linear guiding elements each having a plurality of clamping elements formed on at least one side thereof.

6. The carrier according to one of the preceding claims, wherein the tolerance means comprises a plurality of spring-like means each of which comprises a reception means configured for mechanically contacting an electronic component in the clamped state.

7. The carrier according to claim 6, wherein each of the reception means is shaped such that it mechanically contacts an electronic component in the clamped state at two edges that are connected to each other at a corner.

8. The carrier according to claim 6, wherein each of the reception means is shaped such that it contacts the electronic component at the two edges symmetrically.

9. The carrier according to one of the claims 6 to 8, wherein the plurality of spring-like means is integrally formed with a linear member of the tolerance means.

10. The carrier according to claim 9, wherein the tolerance means is entirely formed of an elastic plastic material.

11. The carrier according to one of the preceding claims, wherein the tolerance means has a shape as shown in Figure 2.

12. The carrier according to one of the preceding claims, wherein the first plate is arranged above the second plate and the tolerance means and wherein in the clamped state of the carrier the electronic components are secured to edges of the openings.

13. The carrier according to one of the preceding claims, further comprising a mechanical, in particular, non-elastic, locking means configured for securing the carrier in the clamped state, wherein the locking means is particularly configured for being locked by a pushing means of a loading station.

14. The carrier according to claim 13, wherein the locking means comprises or is made of a self-locking means, in particular, comprising a metal pin or metal wedge.
The carrier according to one of the preceding claims, wherein the actuator is configured to be actuated by a pushing means of a loading station.
